# NEUE EUROPÄISCHE PATENTSCHRIFT

(11) **EP 2 896 270 B2**
(45) Veröffentlichungstag und Bekanntmachung des Hinweises auf die Entscheidung über den Einspruch: **11.03.2020**
(45) Hinweis auf die Patenterteilung: 05.04.2017
(21) Anmeldenummer: 13735271.2
(22) Anmeldetag: 10.07.2013
(51) Int. Cl.: H05B 3/84, H01R 12/57, H01R 12/53, H01R 4/62

(54) **SCHEIBE MIT EINEM ELEKTRISCHEN ANSCHLUSSELEMENT**
PANE WITH ELECTRIC CONNECTION ELEMENT
DISQUE DOTÉ D'UN ÉLÉMENT DE RACCORDEMENT ÉLECTRIQUE

(30) Priorität: 14.09.2012 EP 12184407
(43) Veröffentlichungstag der Anmeldung: 22.07.2015
(73) Patentinhaber: Saint-Gobain Glass France, 92400 Courbevoie (FR)
(72) Erfinder: SCHMALBUCH, Klaus, 52074 Aachen (DE); REUL, Bernhard, 52134 Herzogenrath (DE); RATEICZAK, Mitja, 52146 Würselen (DE); LESMEISTER, Lothar, 6373 Landgraaf (NL)
(74) Vertreter: Gebauer, Dieter Edmund
(86) Internationale Anmeldenummer: PCT/EP2013/064576
(87) Internationale Veröffentlichungsnummer: WO 2014/040774

(56) Entgegenhaltungen:
- EP-A1- 2 408 260
- EP-A2- 2 218 141
- WO-A1-2012/007303
- WO-A1-2012/152543
- WO-A1-2012/152543
- WO-A1-2014/040773
- DE-U1- 20 203 202
- JP-B2- 3 439 866
- US-A- 2 644 066
- US-A1- 2007 224 842
- US-A1- 2011 056 747
- US-A1- 2012 305 311
- US-B1- 6 406 337
- US-B2- 9 155 206

## Beschreibung

Die Erfindung betrifft eine Scheibe mit einem elektrischen Anschlusselement, ein wirtschaftliches und umweltfreundliches Verfahren zu deren Herstellung und ihre Verwendung.

Die Erfindung betrifft insbesondere eine Scheibe mit einem elektrischen Anschlusselement für Fahrzeuge mit elektrisch leitfähigen Strukturen wie beispielsweise Heizleiter oder Antennenleiter. Die elektrisch leitfähigen Strukturen sind üblicherweise über angelötete elektrische Anschlusselemente mit der Bordelektrik verbunden. Aufgrund unterschiedlicher thermischer Ausdehnungskoeffizienten der verwendeten Materialien treten mechanische Spannungen bei der Herstellung und im Betrieb auf, welche die Scheiben belasten und den Bruch der Scheibe hervorrufen können.

Bleihaltige Lote weisen eine hohe Duktilität auf, die auftretende mechanische Spannungen zwischen elektrischem Anschlusselement und der Scheibe durch plastische Deformierung kompensieren können. Allerdings müssen aufgrund der Altauto-Richtlinie 2000/53/EG innerhalb der EG bleihaltige Lote durch bleifreie Lote ersetzt werden. Die Richtlinie wird zusammenfassend mit dem Kürzel ELV (End of life vehicles) bezeichnet. Das Ziel ist dabei, im Zuge der massiven Ausweitung von Wegwerfelektronik äußerst problematische Bestandteile aus den Produkten zu verbannen. Die betroffenen Substanzen sind Blei, Quecksilber und Cadmium. Das betrifft unter anderem die Durchsetzung von bleifreien Lötmitteln in elektrischen Anwendungen auf Glas und die Einführung entsprechender Ersatzprodukte hierzu.

Es sind eine Reihe von elektrischen Anschlusselementen zum bleifreien Verlöten mit elektrisch leitfähigen Strukturen vorgeschlagen worden. Beispielhaft sei auf die Dokumente US 20070224842 A1, EP 1942703 A2, WO 2007110610 A1, EP 1488972 A1 und EP 2365730 A1 verwiesen. Eine entscheidende Bedeutung hinsichtlich der Vermeidung von thermischen Spannungen kommt einerseits der Form des Anschlusselements und andererseits dem Material des Anschlusselements zu.

Aus der Druckschrift EP 2 408 260 A1 ist eine Scheibe mit mindestens einem elektrischen Anschlusselement bekannt, die mindestens einen Substrat umfasst, wobei auf einem Bereich des Substrats eine elektrisch leitfähige Struktur (2) angeordnet ist, wobei auf einem Bereich der elektrisch leitfähigen Struktur ein Anschlusselement angeordnet ist, das zumindest einen chromhaltigen Stahl enthält, und wobei das Anschlusselement einen um ein Anschlusskabel gecrimpten Bereich und einen Lötbereich aufweist und wobei der Lötbereich über eine bleifreie Lotmasse mit der elektrisch leitfähigen Struktur verbunden ist.

Die Aufgabe der vorliegenden Erfindung ist es, eine Scheibe mit einem elektrischen Anschlusselement bereitzustellen, welches sich insbesondere zum Verlöten mittels bleifreier Lotmassen eignet, wobei kritische mechanische Spannungen in der Scheibe vermieden werden. Außerdem soll ein wirtschaftliches und umweltfreundliches Verfahren zu deren Herstellung bereitgestellt werden.

Die Aufgabe der vorliegenden Erfindung wird erfindungsgemäß durch eine Scheibe mit mindestens einem elektrischen Anschlusselement gemäß dem unabhängigen Anspruch 1 gelöst. Bevorzugte Ausführungen gehen aus den Unteransprüchen hervor.

Die erfindungsgemäße Scheibe mit mindestens einem elektrischen Anschlusselement umfasst zumindest die folgenden Merkmale:
- ein Substrat,
- auf einem Bereich des Substrats eine elektrisch leitfähige Struktur,
- auf einem Bereich der elektrisch leitfähigen Struktur ein Anschlusselement, das zumindest einen chromhaltigen Stahl enthält,
wobei das Anschlusselement einen um ein Anschlusskabel gecrimpten Bereich und einen Lötbereich aufweist und wobei der Lötbereich über eine bleifreie Lotmasse mit der elektrisch leitfähigen Struktur verbunden ist.

Das elektrische Anschlusselement ist erfindungsgemäß durch Crimpen mit dem Anschlusskabel verbunden. Die Crimpverbindung ist einfach, kostengünstig und schnell herzustellen und leicht automatisierbar. Aufwendige zusätzliche Prozessschritte, beispielsweise das Verlöten oder Verschweißen des Anschlusselements mit dem Anschlusskabel können vermieden werden. Gleichzeitig wird eine sehr stabile Verbindung zwischen Anschlusselement und Anschlusskabel bereitgestellt. Das erfindungsgemäße Anschlusselement mit dem gecrimpten Bereich (dem sogenannten Crimp, also dem durch den Crimpvorgang verformte Bereich) und dem Lötbereich kann einfach und kostengünstig hergestellt werden und erlaubt eine platzsparende, flexibel einsetzbare und dauerhaft stabile elektrische Kontaktierung der elektrisch leitfähigen Struktur.

Chromhaltiger, insbesondere sogenannter rostfreier oder nichtrostender Stahl ist kostengünstig verfügbar. Anschlusselemente aus chromhaltigem Stahl weisen zudem im Vergleich zu vielen herkömmlichen Anschlusselementen, beispielsweise aus Kupfer, eine hohe Steifigkeit auf, was zu einer vorteilhaften Stabilität der Crimpverbindung führt. Chromhaltiger Stahl ist gut kaltumformbar, wodurch er sich zur Herstellung von Crimpverbindung besonders eignet. Zudem weist chromhaltiger Stahl im Vergleich zu vielen herkömmlichen Anschlusselementen, beispielsweise solche aus Titan, eine verbesserte Lötbarkeit auf, die sich aus einer höheren Wärmeleitfähigkeit ergibt.

Das Anschlusskabel ist dafür vorgesehen, die elektrisch leitfähige Struktur mit einem externen Funktionselement, beispielsweise einer Spannungsversorgung oder einem Empfangsgerät, elektrisch zu verbinden. Dazu ist das Anschlusskabel ausgehend vom Anschlusselement bevorzugt über die Seitenkanten der Scheibe hinweg von der Scheibe weggeführt. Das Anschlusskabel kann prinzipiell jedes Anschlusskabel sein, das dem Fachmann zur elektrischen Kontaktierung einer elektrisch leitfähigen Struktur bekannt ist und dazu geeignet ist, durch Crimpen mit dem Anschlusselement (auch Crimpkontakt genannt) verbunden zu werden. Das Anschlusskabel kann neben einem elektrisch leitfähigen Kern (Innenleiter) eine isolierende, bevorzugt polymere Ummantelung umfassen, wobei die isolierende Ummantelung bevorzugt im Endbereich des Anschlusskabels entfernt ist, um eine elektrisch leitende Verbindung zwischen Anschlusselement und Innenleiter zu ermöglichen.

Der elektrisch leitfähige Kern des Anschlusskabels kann beispielsweise Kupfer, Aluminium und / oder Silber oder Legierungen oder Gemische davon enthalten. Der elektrisch leitfähige Kern kann beispielsweise als Drahtlitzenleiter oder als Volldrahtleiter ausgeführt sein. Der Querschnitt des elektrisch leitfähigen Kerns des Anschlusskabels richtet sich nach der für die Verwendung der erfindungsgemäßen Scheibe erforderlichen Stromtragfähigkeit und kann vom Fachmann geeignet gewählt werden. Der Querschnitt beträgt beispielsweise von 0,3 mm² bis 6 mm².

Das Anschlusselement, welches erfindungsgemäß zumindest einen chromhaltigen Stahl enthält und bevorzugt aus dem chromhaltigen Stahl besteht, ist bevorzugt im Endbereich des Anschlusskabels um den elektrisch leitfähigen Kern des Anschlusskabels gecrimpt, so dass eine dauerhaft stabile elektrisch leitfähige Verbindung zwischen Anschlusselement und Anschlusskabel entsteht. Das Crimpen erfolgt mit einem geeigneten, dem Fachmann an sich bekannten Crimpwerkzeug, beispielsweise einer Crimpzange oder einer Crimppresse. Das Crimpwerkzeug umfasst üblicherweise zwei Wirkstellen, beispielsweise die Backen einer Crimpzange, welche gegeneinander geführt werden, wodurch ein mechanischer Druck auf das Anschlusselement ausgeübt wird. Das Anschlusselement wird dadurch plastisch verformt und um das Anschlusselement gequetscht.

In einer bevorzugten Ausgestaltung des erfindungsgemäßen elektrischen Anschlusselements ist der Lötbereich an derjenigen Seite des gecrimpten Bereichs angeordnet, die der Erstreckungsrichtung des Anschlusskabels zum externen Funktionselement gegenüberliegt. Die Winkel zwischen dem Lötbereich und dem gecrimpten Bereich beträgt bevorzugt von 120° bis 180°, besonders bevorzugt von 150° bis 170°. Dadurch kann eine besonders platzsparende und stabile elektrische Kontaktierung der elektrisch leitfähigen Struktur erreicht werden.

Die zum Substrat hingewandte Oberfläche des Lötbereichs bildet die Kontaktfläche zwischen Anschlusselement und elektrisch leitfähiger Struktur und ist über die Lotmasse mit der elektrisch leitfähigen Struktur verbunden. Gemeint ist hier eine direkte, mechanische Verbindung zwischen dem Lötbereich und der elektrisch leitfähigen Struktur über die Lotmasse. Das bedeutet, dass Lotmasse zwischen dem Lötbereich und der elektrisch leitfähigen Struktur angeordnet ist und dadurch den Lötbereich dauerhaft stabil auf der elektrisch leitfähigen Struktur fixiert.

Das Anschlusselement weist im Lötbereich und im gecrimpten Bereich bevorzugt die gleiche Materialstärke auf. Das ist besonders vorteilhaft im Hinblick auf eine einfache Herstellung des Anschlusselements, weil das Anschlusselement beispielsweise aus einem einfachen Blech ausgestanzt werden kann. Die Materialstärke des Anschlusselements beträgt bevorzugt von 0,1 mm bis 2 mm, besonders bevorzugt von 0,2 mm bis 1 mm, ganz besonders bevorzugt von 0,3 mm bis 0,5 mm. In diesem Bereich für die Materialstärke weist das Anschlusselement einerseits die zum Crimpen notwendige Kaltumformbarkeit auf. Andererseits wird in diesem Bereich für die Materialstärke eine vorteilhafte Stabilität der Crimpverbindung und eine vorteilhafte elektrische Verbindung zwischen elektrisch leitfähiger Struktur und Anschlusskabel erreicht.

Die Länge und die Breite des Lötbereichs betragen bevorzugt von 1 mm bis 10 mm, besonders bevorzugt von 2 mm bis 8 mm und ganz besonders bevorzugt von 2,5 mm bis 5 mm. Das ist besonders vorteilhaft im Hinblick auf einen geringen Platzbedarf des Anschlusselements und eine effektive elektrische Kontaktierung der elektrisch leitfähigen Struktur.

In einer bevorzugten Ausgestaltung ist der Lötbereich plan ausgebildet, wodurch sich eine plane Kontaktfläche ergibt. Der Lötbereich kann aber auch bevorzugt durch Umformungen wie Prägen oder Tiefziehen eingebrachte Bereiche aufweisen, beispielsweise Lotdepots, Abstandshalter oder Kontakterhebungen. Abseits der umgeformten Bereiche ist die Kontaktfläche bevorzugt plan.

Die Form des Lötbereichs und der Kontaktfläche kann den Erfordernissen im Einzelfall entsprechend gewählt werden und beispielsweise polygonal, rechteckig, rechteckig mit abgerundeten Ecken, oval, elliptisch oder kreisförmig ausgebildet sein.

Die Länge des gecrimpten Bereichs kann vom Fachmann unter Berücksichtigung des Durchmessers des Anschlusskabels sowie gängiger Normen geeignet gewählt werden und beträgt beispielsweise von 2 mm bis 8 mm oder von 4 mm bis 5 mm, insbesondere 4,5 mm. Das ist besonders vorteilhaft im Hinblick auf einen geringen Platzbedarf des Anschlusselements und eine stabile Verbindung zwischen Anschlusselement und Anschlusskabel. Bevorzugt ist Crimp als offener Crimp ausgebildet. Da das Anschlusskabel dabei nicht in eine rundum geschlossene Aderendhülse (geschlossener Crimp) eingesteckt werden muss, ist eine solche Crimpverbindung leichter herzustellen und leichter automatisierbar und eignet sich daher besonders für eine Massenfertigung. Die Form des Crimps kann frei gewählt werden, beispielsweise als B-Crimp oder O-Crimp.

Der Lötbereich kann direkt an den gecrimpten Bereich des Anschlusselements angeschlossen sein. Zwischen dem Lötbereich und dem gecrimpten Bereich kann aber auch ein Übergangsbereich beispielsweise mit einer Länge von 1 mm bis 5 mm angeordnet sein. Durch einen Übergangsbereich wird die Flexibilität bei der Gestaltung des Anschlusselements erhöht.

An den Lötbereich können sich neben dem gecrimpten Bereich auch ein oder mehrere weitere Bereiche anschließen. Beispielsweise kann an der dem gecrimpten Bereich gegenüberliegenden Seitenkante des Lötbereichs ein weiterer Bereich angeordnet sein. Ein solcher weiterer Bereich kann beispielsweise dafür vorgesehen sein, das Anschlusselement mit einer Halterung zu verbinden. Durch eine gemeinsame Halterung können beispielsweise mehrere erfindungsgemäße Anschlusselemente in definierter relativer Anordnung mit der elektrisch leitfähigen Struktur verlötet werden.

Gemäß der Erfindung weist die Scheibe von zwei bis sechs erfindungsgemäße elektrische Anschlusselemente auf. Durch mehrere Anschlusselemente kann beispielsweise eine als Heizleiter ausgebildete elektrisch leitfähige Struktur mit den beiden Polen einer externen Spannungsversorgung verbunden werden. Durch mehrere Anschlusselemente können beispielsweise auch verschiedene, auf das Substrat als elektrisch leitfähige Strukturen aufgebrachte Antennen kontaktiert werden. Aufgrund der geringen Abmessungen und Reduzierung von thermischen Spannungen sind erfindungsgemäße Anschlusselemente besonders für Scheiben geeignet, auf denen mehrere Anschlusselemente auch in geringem Abstand zueinander angeordnet werden sollen. Die Anschlusselemente sind bevorzugt auf einer Linie angeordnet. Der Abstand zwischen benachbarten Anschlusselementen beträgt bevorzugt von 5 mm bis 50 mm, besonders bevorzugt von 10 mm bis 20 mm. Diese Anordnung ist aus verfahrenstechnischen und ästhetischen Gründen vorteilhaft. Insbesondere können die Anschlusselemente in dieser relativen Anordnung beispielsweise vor dem Anlöten in einer gemeinsamen Halterung fixiert werden. Die Seitenkanten der Lötbereiche der verschiedenen Anschlusselemente sind bevorzugt parallel zueinander angeordnet und können in Bezug auf die (gedachte) Linie, auf der die Anschlusselemente angeordnet sind, einen beliebigen Winkel aufweisen, bevorzugt von 5° bis 90°, besonders bevorzugt von 10° bis 40°. Die gecrimpten Bereiche der verschiedenen Anschlusselemente sind bevorzugt auf der gleichen Seite der (gedachten) Linie angeordnet. Eine solche Anordnung ist besonders platzsparend.

Das Substrat weist einen ersten thermischen Ausdehnungskoeffizienten auf. Das Anschlusselement weist einen zweiten thermischen Ausdehnungskoeffizienten auf. Gemäß der Erfindung ist die Differenz zwischen dem ersten und dem zweiten Ausdehnungskoeffizienten kleiner 5 x 10⁻⁶/°C, besonders bevorzugt kleiner 3 x 10⁻⁶/°C. Dadurch werden die thermischen Spannungen der Scheibe reduziert und eine bessere Haftung erreicht.

Das Substrat enthält bevorzugt Glas, besonders bevorzugt Flachglas, Floatglas, Quarzglas, Borosilikatglas und / oder Kalk-Natron-Glas. Das Substrat kann aber auch Polymere enthalten, bevorzugt Polyethylen, Polypropylen, Polycarbonat, Polymethylmethacrylat, Polystyrol, Polybutadien, Polynitrile, Polyester, Polyurethan, Polyvinylchlorid, Polyacrylat, Polyamid, Polyethylenterephthalat und / oder Copolymere oder Gemische davon. Das Substrat ist bevorzugt transparent. Das Substrat weist bevorzugt eine Dicke von 0,5 mm bis 25 mm, besonders bevorzugt von 1 mm bis 10 mm und ganz besonders bevorzugt von 1,5 mm bis 5 mm auf.

Der erste thermische Ausdehnungskoeffizient beträgt von 8 x 10⁻⁶/°C bis 9 x 10⁻⁶/°C. Das Substrat enthält bevorzugt Glas, das bevorzugt einen thermischen Ausdehnungskoeffizienten von 8,3 x 10⁻⁶/°C bis 9 x 10⁻⁶/°C in einem Temperaturbereich von 0 °C bis 300 °C aufweist.

Der zweite thermische Ausdehnungskoeffizient ist von 9 x 10⁻⁶/°C bis 13 x 10⁻⁶/°C, besonders bevorzugt von 10 x 10⁻⁶/°C bis 11,5 x 10⁻⁶/°C, ganz besonders bevorzugt von 10 x 10⁻⁶/°C bis 11 x 10⁻⁶/°C und insbesondere von 10 x 10⁻⁶/°C bis 10,5 x 10⁻⁶/°C in einem Temperaturbereich von 0 °C bis 300 °C.

Das erfindungsgemäße Anschlusselement enthält einen chromhaltigen Stahl mit einem Anteil an Chrom von größer oder gleich 10,5 Gew.-%. Weitere Legierungsbestandteile wie Molybdän, Mangan oder Niob führen zu einer verbesserten Korrosionsbeständigkeit oder veränderten mechanischen Eigenschaften, wie Zugfestigkeit oder Kaltumformbarkeit.

Das erfindungsgemäße Anschlusselement enthält bevorzugt zumindest 66,5 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän, 0 Gew.-% bis 2 Gew.-% Niob und 0 Gew.-% bis 1 Gew.-% Titan. Das Anschlusselement kann zusätzlich Beimengungen weiterer Elemente enthalten, darunter Vanadium, Aluminium und Stickstoff.

Das erfindungsgemäße Anschlusselement enthält besonders bevorzugt zumindest 73 Gew.-% bis 89,5 Gew.-% Eisen, 10,5 Gew.-% bis 20 Gew.-% Chrom, 0 Gew.-% bis 0,5 Gew.-% Kohlenstoff, 0 Gew.-% bis 2,5 Gew.-% Nickel, 0 Gew.-% bis 1 Gew.-% Mangan, 0 Gew.-% bis 1,5 Gew.-% Molybdän, 0 Gew.-% bis 1 Gew.-% Niob und 0 Gew.-% bis 1 Gew.-% Titan. Das Anschlusselement kann zusätzlich Beimengungen weiterer Elemente enthalten, darunter Vanadium, Aluminium und Stickstoff.

Das erfindungsgemäße Anschlusselement enthält ganz besonders bevorzugt zumindest 77 Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan, 0 Gew.-% bis 1 Gew.-% Niob, 0 Gew.-% bis 1,5 Gew.-% Molybdän und 0 Gew.-% bis 1 Gew.-% Titan. Das Anschlusselement kann zusätzlich Beimengungen weiterer Elemente enthalten, darunter Vanadium, Aluminium und Stickstoff.

Besonders geeignete chromhaltige Stähle sind Stähle der Werkstoffnummern 1.4016, 1.4113, 1.4509 und 1.4510 nach EN 10 088-2.

Die erfindungsgemäße elektrisch leitfähige Struktur weist bevorzugt eine Schichtdicke von 5 µm bis 40 µm, besonders bevorzugt von 5 µm bis 20 µm, ganz besonders bevorzugt von 8 µm bis 15 und insbesondere von 10 µm bis 12 µm auf. Die erfindungsgemäße elektrisch leitfähige Struktur enthält bevorzugt Silber, besonders bevorzugt Silberpartikel und Glasfritten.

Die Schichtdicke der Lotmasse ist bevorzugt kleiner oder gleich 6.0 x 10⁻⁴ m, besonders bevorzugt kleiner 3.0 x 10⁻⁴ m.

Die erfindungsgemäße Lotmasse ist bleifrei. Das ist besonders vorteilhaft im Hinblick auf die Umweltverträglichkeit der erfindungsgemäßen Scheibe mit elektrischem Anschlusselement. Als bleifreie Lotmasse ist im Sinne der Erfindung eine Lotmasse zu verstehen, welche entsprechend der EG-Richtlinie "2002/95/EG zur Beschränkung der Verwendung bestimmter gefährlicher Stoffe in Elektro- und Elektronikgeräten" einen Anteil von kleiner oder gleich 0,1 Gew.-% Blei, bevorzugt kein Blei enthält.

Bleifreie Lotmassen weisen typischerweise eine geringere Duktilität auf als bleihaltige Lotmassen, so dass mechanische Spannungen zwischen Anschlusselement und Scheibe weniger gut kompensiert werden können. Es hat sich aber gezeigt, dass kritische mechanische Spannungen durch das erfindungsgemäße Anschlusselement vermieden werden können. Die Lotmasse enthält bevorzugt Zinn und Wismut, Indium, Zink, Kupfer, Silber oder Zusammensetzungen davon. Der Anteil an Zinn in der erfindungsgemäßen Lotzusammensetzung beträgt von 3 Gew.-% bis 99,5 Gew.-%, bevorzugt von 10 Gew.-% bis 95,5 Gew.-%, besonders bevorzugt von 15 Gew.-% bis 60 Gew.-%. Der Anteil an Wismut, Indium, Zink, Kupfer, Silber oder Zusammensetzungen davon beträgt in der erfindungsgemäßen Lotzusammensetzung von 0,5 Gew.-% bis 97 Gew.-%, bevorzugt 10 Gew.-% bis 67 Gew.-%, wobei der Anteil an Wismut, Indium, Zink, Kupfer oder Silber 0 Gew.-% betragen kann. Die Lotzusammensetzung kann Nickel, Germanium, Aluminium oder Phosphor mit einem Anteil von 0 Gew.-% bis 5 Gew.-% enthalten. Die erfindungsgemäße Lotzusammensetzung enthält ganz besonders bevorzugt Bi40Sn57Ag3, Sn40Bi57Ag3, Bi59Sn40Ag1, Bi57Sn42Ag1, In97Ag3, Sn95,5Ag3,8Cu0,7, Bi67In33, Bi33In50Sn17, Sn77,2In20Ag2,8, Sn95Ag4Cu1, Sn99Cu1, Sn96,5Ag3,5, Sn96,5Ag3Cu0,5, Sn97Ag3 oder Gemische davon.

In einer vorteilhaften Ausgestaltung enthält die Lotmasse Wismut. Es hat sich gezeigt, dass eine Wismut-haltige Lotmasse zu einer besonders guten Haftung des erfindungsgemäßen Anschlusselements an der Scheibe führt, wobei Beschädigungen der Scheibe vermieden werden können. Der Anteil des Wismuts an der Lotmassenzusammensetzung beträgt bevorzugt von 0,5 Gew.-% bis 97 Gew.-%, besonders bevorzugt von 10 Gew.-% bis 67 Gew.-% und ganz besonders bevorzugt von 33 Gew.-% bis 67 Gew.-%, insbesondere von 50 Gew.-% bis 60 Gew.-%. Die Lotmasse enthält neben Wismut bevorzugt Zinn und Silber oder Zinn, Silber und Kupfer. In einer besonders bevorzugten Ausgestaltung enthält die Lotmasse zumindest 35 Gew.-% bis 69 Gew.-% Wismut, 30 Gew.-% bis 50 Gew.-% Zinn, 1 Gew.-% bis 10 Gew.-% Silber und 0 Gew.-% bis 5 Gew.-% Kupfer. In einer ganz besonders bevorzugten Ausgestaltung enthält die Lotmasse zumindest 49 Gew.-% bis 60 Gew.-% Wismut, 39 Gew.-% bis 42 Gew.-% Zinn, 1 Gew.-% bis 4 Gew.-% Silber und 0 Gew.-% bis 3 Gew.-% Kupfer.

In einer weiteren vorteilhaften Ausgestaltung enthält die Lotmasse von 90 Gew.-% bis 99,5 Gew.-% Zinn, bevorzugt von 95 Gew.-% bis 99 Gew.-%, besonders bevorzugt von 93 Gew.-% bis 98 Gew.-%. Die Lotmasse enthält neben Zinn bevorzugt von 0,5 Gew.-% bis 5 Gew.-% Silber und von 0 Gew.-% bis 5 Gew.-% Kupfer.

Die Lotmasse tritt mit einer Austrittsbreite von bevorzugt kleiner 1 mm aus dem Zwischenraum zwischen dem Lötbereich des Anschlusselements und der elektrisch leitfähigen Struktur aus. In einer bevorzugten Ausgestaltung ist die maximale Austrittsbreite kleiner 0,5 mm und insbesondere etwa 0 mm. Das ist besonders vorteilhaft im Hinblick auf die Reduzierung von mechanischen Spannungen in der Scheibe, die Haftung des Anschlusselements und die Einsparung des Lots. Die maximale Austrittsbreite ist definiert als der Abstand zwischen den Außenkanten des Lötbereichs und der Stelle des Lotmasseübertritts, an dem die Lotmasse eine Schichtdicke von 50 µm unterschreitet. Die maximale Austrittsbreite wird nach dem Lötvorgang an der erstarrten Lotmasse gemessen. Eine gewünschte maximale Austrittsbreite wird durch eine geeignete Wahl von Lotmassenvolumen und lotrechtem Abstand zwischen Anschlusselement und elektrisch leitfähiger Struktur erreicht, was durch einfache Versuche ermittelt werden kann. Der lotrechte Abstand zwischen Anschlusselement und elektrisch leitfähiger Struktur kann durch ein entsprechendes Prozesswerkzeug, beispielsweise ein Werkzeug mit einem integrierten Abstandshalter, vorgegeben werden. Die maximale Austrittsbreite kann auch negativ sein, also in den vom Lötbereich des elektrischen Anschlusselements und elektrisch leitfähiger Struktur gebildeten Zwischenraum zurückgezogen sein. In einer vorteilhaften Ausgestaltung der erfindungsgemäßen Scheibe ist die maximale Austrittsbreite in dem vom Lötbereich des elektrischen Anschlusselements und der elektrisch leitfähigen Struktur gebildeten Zwischenraum in einem konkaven Meniskus zurückgezogen. Ein konkaver Meniskus entsteht beispielsweise durch Erhöhen des lotrechten Abstands zwischen Abstandshalter und leitfähiger Struktur beim Lötvorgang, während das Lot noch flüssig ist. Der Vorteil liegt in der Reduzierung der mechanischen Spannungen in der Scheibe, insbesondere im kritischen Bereich, der bei einem großen Lotmasseübertritt vorliegt.

In einer vorteilhaften Ausgestaltung der Erfindung weist die Kontaktfläche des Anschlusselements Abstandshalter auf, bevorzugt mindestens zwei Abstandshalter, besonders bevorzugt mindestens drei Abstandshalter. Die Abstandshalter sind bevorzugt einstückig mit dem Anschlusselement ausgebildet, beispielsweise durch Prägen oder Tiefziehen. Die Abstandshalter haben bevorzugt eine Breite von 0,5 x 10⁻⁴ m bis 10 x 10⁻⁴ m und eine Höhe von 0,5 x 10⁻⁴ m bis 5 x 10⁻⁴ m, besonders bevorzugt von 1x 10⁻⁴ m bis 3 x 10⁻⁴ m. Durch die Abstandshalter wird eine homogene, gleichmäßig dicke und gleichmäßig aufgeschmolzene Schicht der Lotmasse erreicht. Dadurch können mechanische Spannungen zwischen Anschlusselement und Scheibe verringert werden und die Haftung des Anschlusselements verbessert werden. Das ist insbesondere bei der Verwendung bleifreier Lotmassen besonders vorteilhaft, die aufgrund ihrer geringeren Duktilität im Vergleich zu bleihaltigen Lotmassen mechanische Spannungen weniger gut kompensieren können.

In einer vorteilhaften Ausgestaltung der Erfindung ist auf der vom Substrat abgewandten Oberfläche des Lötbereichs des Anschlusselements zumindest eine Kontakterhebung angeordnet, welche der Kontaktierung des Anschlusselements mit dem Lötwerkzeug während des Lötvorgangs dient. Die Kontakterhebung ist bevorzugt zumindest im Bereich der Kontaktierung mit dem Lötwerkzeug konvex gekrümmt ausgeformt. Die Kontakterhebung hat bevorzugt eine Höhe von 0,1 mm bis 2 mm, besonders bevorzugt von 0,2 mm bis 1 mm. Die Länge und Breite der Kontakterhebung beträgt bevorzugt zwischen 0,1 und 5 mm, ganz besonders bevorzugt zwischen 0,4 mm und 3 mm. Die Kontakterhebungen sind bevorzugt einstückig mit dem Anschlusselement ausgebildet, beispielsweise durch Prägen oder Tiefziehen. Zum Löten können Elektroden verwendet werden, deren Kontaktseite flach ausgeformt ist. Die Elektrodenfläche wird mit der Kontakterhebung in Kontakt gebracht. Die Elektrodenfläche ist dabei parallel zur Oberfläche des Substrats angeordnet. Der Kontaktbereich zwischen Elektrodenfläche und Kontakterhebung bildet die Lötstelle. Die Position der Lötstelle wird dabei durch den Punkt auf der konvexen Oberfläche der Kontakterhebung bestimmt, der den größten lotrechten Abstand zur Oberfläche des Substrats aufweist. Die Position der Lötstelle ist unabhängig von der Position der Lötelektrode auf dem Anschlusselement. Das ist besonders vorteilhaft im Hinblick auf eine reproduzierbare, gleichmäßige Wärmeverteilung während des Lötvorgangs. Die Wärmeverteilung während des Lötvorgangs wird durch die Position, die Größe, die Anordnung und die Geometrie der Kontakterhebung bestimmt.

Das elektrische Anschlusselement weist bevorzugt zumindest auf der zur Lotmasse ausgerichteten Kontaktfläche eine Beschichtung (Benetzungsschicht) auf, die Nickel, Kupfer, Zink, Zinn, Silber, Gold oder Legierungen oder Schichten davon, bevorzugt Silber enthält. Dadurch wird eine verbesserte Benetzung des Anschlusselements mit der Lotmasse und eine verbesserte Haftung des Anschlusselements erreicht.

Das erfindungsgemäße Anschlusselement ist bevorzugt mit Nickel, Zinn, Kupfer und / oder Silber beschichtet. Das erfindungsgemäße Anschlusselement ist besonders bevorzugt mit einer haftvermittelnden Schicht, bevorzugt aus Nickel und / oder Kupfer, und zusätzlich mit einer lötbaren Schicht, bevorzugt aus Silber, versehen. Das erfindungsgemäße Anschlusselement ist ganz besonders bevorzugt mit 0,1 µm bis 0,3 µm Nickel und / oder 3 µm bis 20 µm Silber beschichtet. Das Anschlusselement kann vernickelt, verzinnt, verkupfert und / oder versilbert werden. Nickel und Silber verbessern die Stromtragfähigkeit und Korrosionsstabilität des Anschlusselements und die Benetzung mit der Lotmasse.

Die Form des elektrischen Anschlusselementes kann ein oder mehrere Lotdepots im Zwischenraum von Anschlusselement und elektrisch leitfähiger Struktur ausbilden. Die Lotdepots und Benetzungseigenschaften des Lotes am Anschlusselement verhindern den Austritt der Lotmasse aus dem Zwischenraum. Lotdepots können rechtwinklig, verrundet oder polygonal ausgestaltet sein.

Die Aufgabe der Erfindung wird weiter durch ein Verfahren zur Herstellung einer erfindungsgemäßen Scheibe mit mindestens einem elektrischen Anschlusselement gelöst, wobei
a) das Anschlusselement durch Crimpen in einem Bereich mit dem Anschlusskabel verbunden wird,
b) Lotmasse auf der Unterseite des Lötbereichs aufgebracht wird,
c) das Anschlusselement mit der Lotmasse auf einem Bereich einer elektrisch leitfähigen Struktur, welche auf einem Bereich eines Substrats aufgebracht ist, angeordnet wird und
d) das Anschlusselement mit der elektrisch leitfähigen Struktur unter Energieeintrag verbunden wird.

Die Lotmasse wird bevorzugt als Plättchen oder abgeflachter Tropfen mit festgelegter Schichtdicke, Volumen, Form und Anordnung auf dem Anschlusselement angebracht. Die Schichtdicke des Lotmasseplättchens beträgt bevorzugt kleiner oder gleich 0,6 mm. Die Form des Lotmasseplättchens entspricht bevorzugt der Form der Kontaktfläche. Ist die Kontaktfläche beispielsweise rechteckig ausgebildet, so weist das Lotmasseplättchen bevorzugt eine rechteckige Form auf.

Das Einbringen der Energie beim elektrischen Verbinden von elektrischem Anschlusselement und elektrisch leitfähiger Struktur erfolgt bevorzugt mit Stempel, Thermoden, Kolbenlöten, bevorzugt Laserlöten, Heißluftlöten, Induktionslöten, Widerstandslöten und/oder mit Ultraschall.

Die elektrisch leitfähige Struktur kann durch an sich bekannte Verfahren auf das Substrat aufgebracht werden, beispielsweise durch Siebdruck-Verfahren. Das Aufbringen der elektrisch leitfähigen Struktur kann zeitlich vor, während oder nach den Verfahrensschritten (a) und (b) erfolgen.

Das Anschlusselement wird bevorzugt in Heizscheiben oder in Scheiben mit Antennen in Gebäuden, insbesondere in Automobilen, Eisenbahnen, Flugzeugen oder Seefahrzeugen verwendet. Das Anschlusselement dient dazu, die leitenden Strukturen der Scheibe mit elektrischen Systemen zu verbinden, welche außerhalb der Scheibe angeordnet sind. Die elektrischen Systeme sind Verstärker, Steuereinheiten oder Spannungsquellen.

Die Erfindung umfasst weiter die Verwendung der erfindungsgemäßen Scheibe in Gebäuden oder in Fortbewegungsmitteln für den Verkehr auf dem Lande, in der Luft oder zu Wasser, insbesondere in Schienenfahrzeugen oder Kraftfahrzeugen, bevorzugt als Windschutzscheibe, Heckscheibe, Seitenscheibe und / oder Dachscheibe, insbesondere als beheizbare Scheibe oder als Scheibe mit Antennenfunktion.

Die Erfindung wird anhand einer Zeichnung und Ausführungsbeispielen näher erläutert.. Die Zeichnung ist eine schematische Darstellung und nicht maßstabsgetreu. Die Zeichnung schränkt die Erfindung in keiner Weise ein. Es zeigen:
- Fig. 1: eine Draufsicht auf eine erste Ausgestaltung der erfindungsgemäßen Scheibe,
- Fig. 2: einen Schnitt A-A' durch die Scheibe gemäß Figur 1,
- Fig. 3: einen Schnitt A-A' durch eine alternative erfindungsgemäße Scheibe,
- Fig. 4: einen Schnitt A-A' durch eine weitere alternative erfindungsgemäße Scheibe,
- Fig. 5: einen Schnitt A-A' durch eine weitere alternative erfindungsgemäße Scheibe,
- Fig. 6: einen Schnitt B-B' durch eine weitere alternative erfindungsgemäße Scheibe,
- Fig. 7: einen Schnitt B-B' durch eine weitere alternative erfindungsgemäße Scheibe,
- Fig. 8: ein detailliertes Flussdiagramm des erfindungsgemäßen Verfahrens.

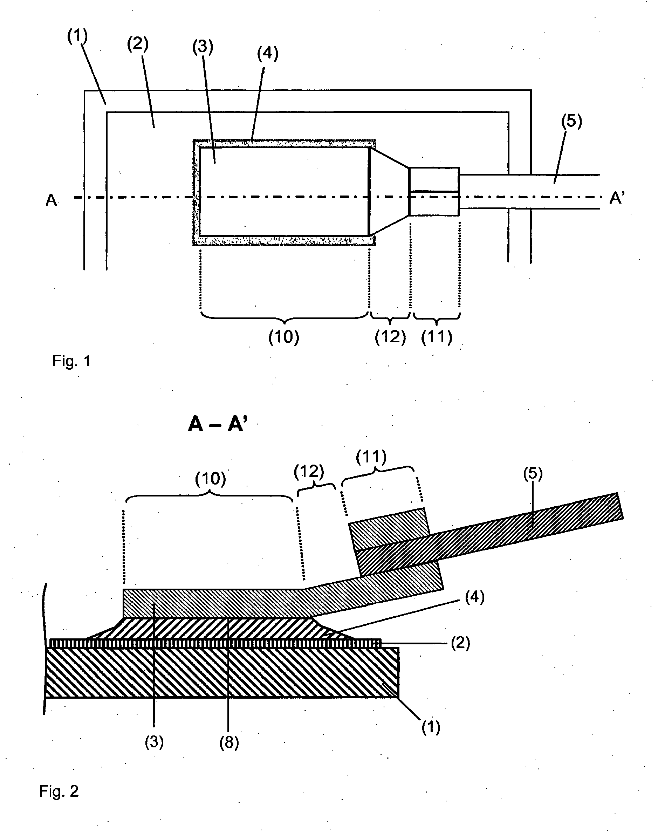

Fig.1 und Fig. 2 zeigen je ein Detail einer erfindungsgemäßen Scheibe im Bereich des elektrischen Anschlusselements 3. Die Scheibe umfasst ein Substrat 1, welches ein 3 mm dickes thermisch vorgespanntes Einscheibensicherheitsglas aus Natron-Kalk-Glas ist. Das Substrat 1 weist eine Breite von 150 cm und eine Höhe von 80 cm auf. Auf das Substrat 1 ist eine elektrisch leitfähige Struktur 2 in Form einer Heizleiterstruktur aufgedruckt. Die elektrisch leitfähige Struktur 2 enthält Silberpartikel und Glasfritten. Im Randbereich der Scheibe ist die elektrisch leitfähige Struktur 2 auf eine Breite von 10 mm verbreitert und bildet eine Kontaktfläche für ein elektrisches Anschlusselement 3. Das Anschlusselement 3 dient der elektrischen Kontaktierung der elektrisch leitfähigen Struktur 2 mit einer externen Spannungsversorgung über ein Anschlusskabel 5. Das Anschlusskabel 5 enthält einen elektrisch leitfähigen Kern, welcher als herkömmlicher Drahtlitzenleiter aus Kupfer ausgebildet ist. Das Anschlusskabel 5 enthält weiter eine nicht dargestellte polymere Isolierummantelung, welche im Endbereich auf eine Länge von 4,5 mm entfernt ist, um die elektrische Kontaktierung des elektrisch leitfähigen Kerns des Anschlusskabels 5 mit dem Anschlusselement 3 zu ermöglichen. Im Randbereich des Substrats 1 befindet sich weiter ein nicht dargestellter Abdecksiebdruck.

Das elektrische Anschlusselement 3 besteht aus Stahl der Werkstoff-Nummer 1.4509 nach EN 10 088-2 (ThyssenKrupp Nirosta® 4509) mit einem thermischen Ausdehnungskoeffizienten von 10,5 x 10⁻⁶/°C im Temperaturbereich von 20°C bis 300°C. Die Materialstärke des Anschlusselements 3 beträgt beispielsweise 0,4 mm. Das Anschlusselement weist einen Bereich 11 mit einer Länge von beispielsweise 4 mm auf, der um den Endbereich des Anschlusskabels 5 gecrimpt ist. Dazu sind die Seitenkanten des gecrimpten Bereichs 11 um das Anschlusskabel 5 herum gebogen und mit diesem verquetscht. Der Crimp ist so angeordnet, dass die umgebogenen Bereiche vom Substrat 1 weg weisen. Dadurch kann ein vorteilhaft kleiner Winkel zwischen gecrimptem Bereich 11 und Substrat 1 realisiert werden. Prinzipiell ist aber auch die umgekehrte Anordnung des Crimps möglich.

Das Anschlusselement 3 weist weiter einen im Wesentlichen rechteckigen, planen Lötbereich 10 auf, welcher über einen Übergangsbereich 12 mit dem gecrimpten Bereich 11 verbunden ist. Der Lötbereich 10 weist beispielweise eine Länge von 4 mm und eine Breite von 2,5 mm auf. Der Übergangsbereich 12 weist beispielsweise eine Länge von 1 mm auf. Der Lötbereich 10 ist an derjenigen Seite des gecrimpten Bereichs 11 angeordnet, die der Erstreckungsrichtung des Anschlusskabels 5 gegenüberliegt. Der Winkel zwischen dem Lötbereich 10 und dem gecrimpten Bereich 11 beträgt beispielsweise 160°. Der Übergangsbereich 12 ist plan ausgebildet, kann aber alternativ beispielsweise auch gekrümmt und / oder geknickt ausgebildet sein.

Die dem Substrat 1 zugewandte Oberfläche des Lötbereichs 10 bildet eine Kontaktfläche 8 zwischen dem elektrischen Anschlusselement 3 und der elektrisch leitfähigen Struktur 2 aus. Im Bereich der Kontaktfläche 8 ist Lotmasse 4 aufgebracht, die eine dauerhafte elektrische und mechanische Verbindung zwischen dem elektrischen Anschlusselement 3 und der elektrisch leitfähigen Struktur 2 bewirkt. Die Lotmasse 4 enthält 57 Gew.-% Wismut, 40 Gew.-% Zinn und 3 Gew.-% Silber. Die Lotmasse 4 hat eine Dicke von 250 µm. Der Lötbereich 10 ist über die Kontaktfläche 8 vollflächig mit der elektrisch leitfähigen Struktur 2 verbunden.

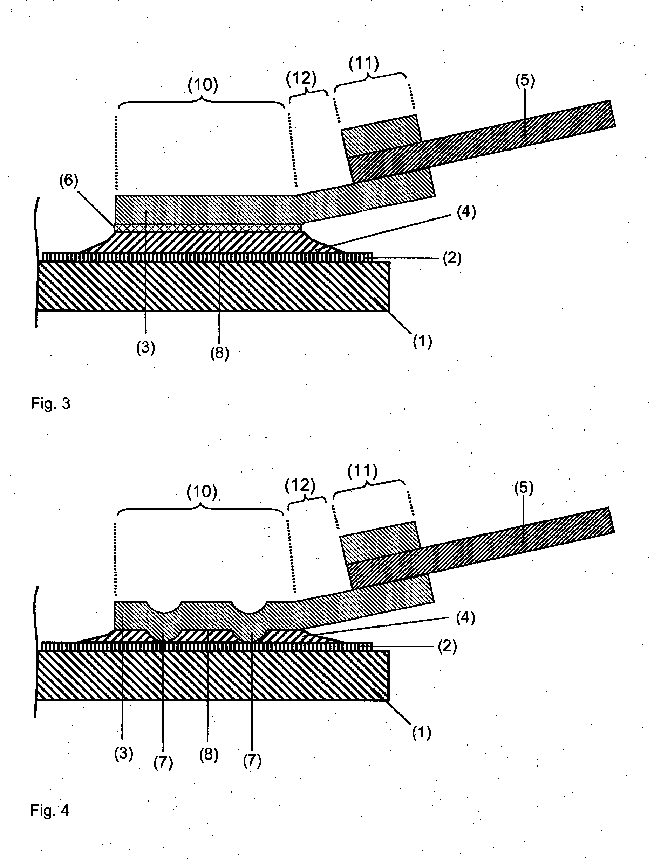

Fig. 3 zeigt einen Querschnitt durch eine alternative Ausgestaltung der erfindungsgemäßen Scheibe mit dem Anschlusselement 3. Die Kontaktfläche 8 des Anschlusselements 3 ist mit einer silberhaltigen Benetzungsschicht 6 versehen, beispielsweise mit einer Dicke von etwa 5 µm. Dadurch wird die Haftung des Anschlusselements 3 verbessert. In einer weiteren Ausgestaltung kann sich zwischen Anschlusselement 3 und Benetzungsschicht 6 eine haftvermittelnde Schicht, beispielsweise aus Nickel und / oder Kupfer, befinden.

Fig. 4 zeigt einen Querschnitt durch eine alternative Ausgestaltung der erfindungsgemäßen Scheibe mit dem Anschlusselement 3. Auf der Kontaktfläche 8 des Anschlusselements 3 sind Abstandshalter 7 angeordnet. Es können beispielsweise vier Abstandshalter 7 auf der Kontaktfläche 8 angeordnet sein, von denen im dargestellten Schnitt zwei Abstandshalter 7 zu erkennen ist. Die Abstandshalter 7 sind in den Lötbereich 10 des Anschlusselements 3 eingeprägt und somit einstückig mit dem Anschlusselement 3 ausgebildet. Die Abstandshalter 7 sind als Kugelsegmente ausgeformt und haben eine Höhe von 2,5 x 10⁻⁴ m und eine Breite von 5 x 10⁻⁴ m. Durch die Abstandshalter 7 wird die Ausbildung einer gleichmäßigen Schicht der Lotmasse 4 begünstigt. Das ist besonders vorteilhaft in Hinblick auf die Haftung des Anschlusselements 3.

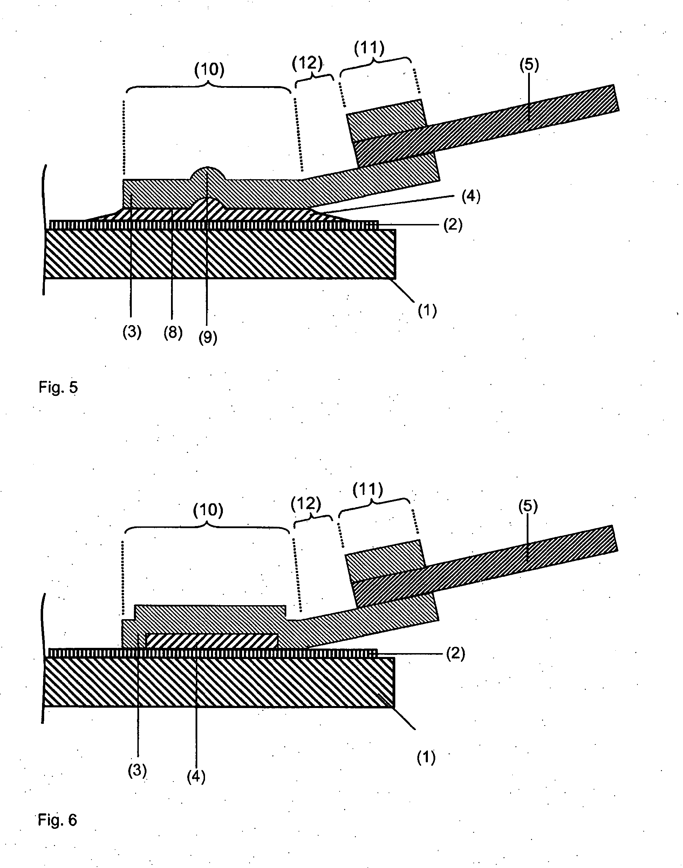

Fig. 5 zeigt einen Querschnitt durch eine alternative Ausgestaltung der erfindungsgemäßen Scheibe mit dem Anschlusselement 3. Auf der der Kontaktfläche 8 gegenüberliegenden, vom Substrat 1 abgewandten Oberfläche des Lötbereichs 10 des Anschlusselements 3 ist eine Kontakterhebung 9 angeordnet. Die Kontakterhebung 9 ist in den Lötbereich 10 des Anschlusselements 3 eingeprägt und somit einstückig mit dem Anschlusselement 3 ausgebildet. Die Kontakterhebung 9 ist als Kugelsegment ausgeformt und hat eine Höhe von 2,5 x 10⁻⁴ m und eine Breite von 5 x 10⁻⁴ m. Die Kontakterhebung 9 dient der Kontaktierung des Anschlusselements 3 mit dem Lötwerkzeug während des Lötvorgangs. Durch die Kontakterhebung 9 wird eine reproduzierbare und definierte Wärmeverteilung unabhängig von der exakten Positionierung des Lötwerkzeugs sichergestellt.

Fig. 6 zeigt einen Querschnitt durch eine alternative Ausgestaltung der erfindungsgemäßen Scheibe mit dem Anschlusselement 3. Das elektrische Anschlusselement 3 enthält auf der zur Lotmasse 4 hin ausgerichteten Kontaktfläche 8 eine Aussparung mit einer Tiefe von 250 µm, die in den Lötbereich 10 eingeprägt ist und die ein Lotdepot für die Lotmasse 4 bildet. Ein Austritt der Lotmasse 4 aus dem Zwischenraum kann vollständig verhindert werden. Dadurch werden die thermischen Spannungen in der Scheibe weiter reduziert.

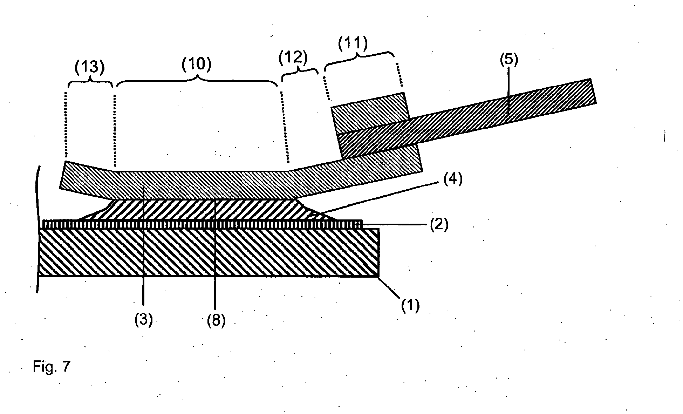

Fig. 7 zeigt einen Querschnitt durch eine alternative Ausgestaltung der erfindungsgemäßen Scheibe mit dem Anschlusselement 3. Das Anschlusselement 3 weist neben dem gecrimpten Bereich 11, dem Übergangsbereich 12 und dem Lötbereich 10 einen weiteren Bereich 13 auf, der an den Lötbereich 10 angrenzt. Der weitere Bereich 13 und der Übergangsbereich 12 mit dem gecrimpten Bereich 11 schließen sich an gegenüberliegende Kanten des Lötbereichs 10 an.

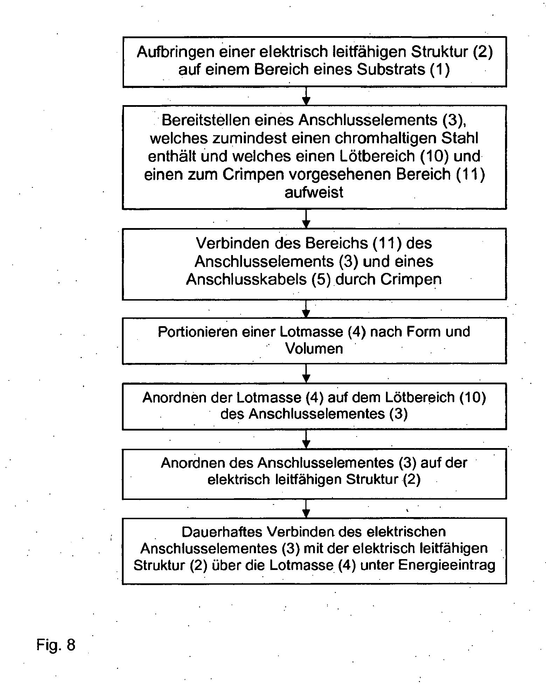

Fig. 8 zeigt detailliert ein erfindungsgemäßes Verfahren zur Herstellung einer Scheibe mit elektrischem Anschlusselement 3.

Testproben wurden angefertigt mit dem Substrat 1 (Dicke 3 mm, Breite 150 cm und Höhe 80 cm), der elektrisch leitfähigen Struktur 2 in Form einer Heizleiterstruktur, dem elektrischen Anschlusselement 3 gemäß Figur 1 und der Lotmasse 4. Das Anschlusselement 3 bestand aus Stahl der Werkstoff-Nummer 1.4509 nach EN 10 088-2, der einen thermischen Ausdehnungskoeffizienten von 10,0 x 10⁻⁶/°C im Temperaturbereich von 20°C bis 200°C und einen thermischen Ausdehnungskoeffizienten von 10,5 x 10⁻⁶/°C im Temperaturbereich von 20°C bis 300°C aufweist. Das Substrat 1 bestand aus Natron-Kalk-Glas mit einem thermischen Ausdehnungskoeffizienten von 8,30 x 10⁻⁶/°C im Temperaturbereich von 20°C bis 300°C. Die Lotmasse 4 enthielt Sn40Bi57Ag3 und wies eine Schichtdicke von 250 µm auf. Das Anschlusselement 3 wurde bei einer Temperatur von 200 °C und einer Behandlungsdauer von 2 Sekunden auf der elektrisch leitfähigen Struktur 2 angelötet. Es wurden keine kritischen mechanischen Spannungen in der Scheibe beobachtet. Die Verbindung der Scheibe mit dem elektrischen Anschlusselement 3 war über die elektrisch leitfähige Struktur 2 dauerhaft stabil. Bei sämtlichen Proben konnte bei einem Temperaturunterschied von +80 °C auf -30 °C beobachtet werden, dass kein Substrat 1 brach oder Schäden aufwies. Es konnte gezeigt werden, dass kurz nach dem Anlöten die Scheiben mit angelöteten Anschlusselement 3 gegen plötzlichen Temperaturabfall stabil waren.

In Vergleichsbeispielen mit Anschlusselementen, welche die gleiche Form aufwiesen und aus Kupfer oder Messing bestanden, traten deutlich höhere mechanische Spannungen auf und bei einem plötzlichen Temperaturunterschied von +80 °C auf -30 °C wurde beobachtet, dass die Scheiben kurz nach dem Anlöten überwiegend Schäden aufwiesen. Es hat sich gezeigt, dass erfindungsgemäße Scheiben mit Glassubstraten 1 und erfindungsgemäßen elektrischen Anschlusselementen 3 eine bessere Stabilität gegen plötzliche Temperaturunterschiede aufwiesen. Dieses Ergebnis war für den Fachmann unerwartet und überraschend.

### Bezugszeichenliste

- (1): Substrat
- (2): elektrisch leitfähige Struktur
- (3): elektrisches Anschlusselement
- (4): Lotmasse
- (5): Anschlusskabel
- (6): Benetzungsschicht
- (7): Abstandshalter
- (8): Kontaktfläche des Anschlusselements 3 mit der elektrisch leitfähigen Struktur 2
- (9): Kontakterhebung
- (10): Lötbereich des Anschlusselements 3
- (11): gecrimpter Bereich des Anschlusselements 3
- (12): Übergangsbereich zwischen gecrimptem Bereich 11 und Lötbereich 10
- (13): weiterer Bereich des Anschlusselements 3

- A-A': Schnittlinie

## Patentansprüche

1. Eine Scheibe mit mindestens einem elektrischen Anschlusselement (3), mindestens umfassend:
- ein Substrat (1), welches einen ersten thermischen Ausdehnungskoeffizienten aufweist, wobei der erste thermische Ausdehnungskoeffizient von 8 x 10⁻⁶/°C bis 9 x 10⁻⁶/°C beträgt,
- auf einem Bereich des Substrats (1) eine elektrisch leitfähige Struktur (2),
- auf einem Bereich der elektrisch leitfähigen Struktur (2) mindestens ein Anschlusselement (3), wobei das Anschlusselement (3) einen um ein Anschlusskabel (5) gecrimpten Bereich (11) und einen Lötbereich (10) aufweist und wobei der Lötbereich (10) über eine bleifreie Lotmasse (4) mit der elektrisch leitfähigen Struktur (2) verbunden ist, wobei das Anschlusselement (3) zumindest einen chromhaltigen Stahl mit einem Anteil an Chrom von größer oder gleich 10,5 Gew.-% enthält, wobei das Anschlusselement (3) einen zweiten thermischen Ausdehnungskoeffizienten aufweist, wobei der zweite thermische Ausdehnungskoeffizient von 9 x 10⁻⁶/°C bis 13 x 10⁻⁶/°C beträgt, und wobei die Differenz zwischen dem ersten thermischen Ausdehnungskoeffizienten und dem zweiten thermischen Ausdehnungskoeffizienten kleiner 5 x 10⁻⁶/°C ist, und
wobei zwei bis sechs Anschlusselemente (3) auf einer Linie angeordnet sind.

2. Scheibe nach Anspruch 1, wobei der Winkel zwischen dem Lötbereich (10) und dem gecrimpten Bereich (11) von 120° bis 180°, bevorzugt von 150° bis 170° beträgt.

3. Scheibe nach Anspruch 1 oder 2, wobei der Abstand benachbarter Anschlusselemente von 5 mm bis 50 mm, besonders bevorzugt von 10 mm bis 20 mm beträgt.

4. Scheibe nach einem der Ansprüche 1 bis 3, wobei die Materialstärke des Anschlusselements (3) von 0,1 mm bis 2 mm, bevorzugt von 0,2 mm bis 1 mm, besonders bevorzugt von 0,3 mm bis 0,5 mm beträgt.

5. Scheibe nach einem der Ansprüche 1 bis 4, wobei das Anschlusselement (3) zumindest 66,5 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän, 0 Gew.-% bis 2 Gew.-% Niob und 0 Gew.-% bis 1 Gew.-% Titan enthält.

6. Scheibe nach Anspruch 5, wobei das Anschlusselement (3) zumindest 77Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan, 0 Gew.-% bis 1 Gew.-% Niob, 0 Gew.-% bis 1,5 Gew.-% Molybdän und 0 Gew.-% bis 1 Gew.-% Titan enthält.

7. Scheibe nach einem der Ansprüche 1 bis 6, wobei das Substrat (1) Glas enthält, bevorzugt Flachglas, Floatglas, Quarzglas, Borosilikatglas und/oder Kalk-Natron-Glas.

8. Scheibe nach einem der Ansprüche 1 bis 7, wobei die elektrisch leitfähige Struktur (2) zumindest Silber, bevorzugt Silberpartikel und Glasfritten enthält und eine Schichtdicke von 5 µm bis 40 µm aufweist.

9. Scheibe nach einem der Ansprüche 1 bis 8, wobei die Schichtdicke der Lotmasse (4) kleiner oder gleich 6.0 x 10⁻⁴ m ist.

10. Scheibe nach einem der Ansprüche 1 bis 9, wobei die Lotmasse (4) Zinn und Wismut, Indium, Zink, Kupfer, Silber oder Zusammensetzungen davon enthält.

11. Scheibe nach Anspruch 10, wobei die Lotmasse (4) 35 Gew.-% bis 69 Gew.-% Wismut, 30 Gew.-% bis 50 Gew.-% Zinn, 1 Gew.-% bis 10 Gew.-% Silber und 0 Gew.-% bis 5 Gew.-% Kupfer enthält oder wobei die Lotmasse (4) 90 Gew.-% bis 99,5 Gew.-% Zinn, 0,5 Gew.-% bis 5 Gew.-% Silber und 0 Gew.-% bis 5 Gew.-% Kupfer enthält.

12. Scheibe nach einem der Ansprüche 1 bis 11, wobei das Anschlusselement (3) zumindest eine Benetzungsschicht (6) aufweist, welche Nickel, Zinn, Kupfer und / oder Silber enthält.

13. Verfahren zur Herstellung einer Scheibe mit mindestens einem elektrischen Anschlusselement nach einem der Ansprüche 1 bis 12, wobei
a) das Anschlusselement (3) durch Crimpen in einem Bereich (11) mit dem Anschlusskabel (5) verbunden wird,
b) Lotmasse (4) auf der Unterseite des Lötbereichs (10) aufgebracht wird,
c) das Anschlusselement (3) mit der Lotmasse (4) auf einem Bereich einer elektrisch leitfähigen Struktur (2), welche auf einem Bereich eines Substrats (1) aufgebracht ist, angeordnet wird und
d) das Anschlusselement (3) mit der elektrisch leitfähigen Struktur (2) unter Energieeintrag verbunden wird.

14. Verwendung einer Scheibe mit mindestens einem elektrischen Anschlusselement nach einem der Ansprüche 1 bis 12, in Gebäuden oder in Fortbewegungsmitteln für den Verkehr auf dem Lande, in der Luft oder zu Wasser, insbesondere in Schienenfahrzeugen oder Kraftfahrzeugen, bevorzugt als Windschutzscheibe, Heckscheibe, Seitenscheibe und / oder Dachscheibe, insbesondere als beheizbare Scheibe oder als Scheibe mit Antennenfunktion.

## Claims

1. A pane with at least one electrical connection element, comprising at least:
- a substrate (1) having a first coefficient of thermal expansion, wherein the first coefficient of thermal expansion is from 8 x 10⁻⁶/°C to 9 x 10⁻⁶/°C,
- on a region of the substrate (1), an electrically conductive structure (2),
- on a region of the electrically conductive structure (2) at least one connection element (3), wherein the connection element (3) has a region (11) crimped around a connection cable (5) and a solder region (10) and wherein the solder region (10) is connected to the electrically conductive structure (2) via a leadfree solder material (4), wherein the connection element (3) comprises at least a chromium-containing steel with a chromium proportion greater than or equal to 10.5 wt.-%, wherein the connection element (3) has a second coefficient of thermal expansion, wherein the second coefficient of thermal expansion is from 9 x 10⁻⁶/°C to 13 x 10⁻⁶/°C, and wherein the difference between the first coefficient of thermal expansion and the second coefficient of thermal expansion is less than 5 x 10⁻⁶/°C, and wherein two to six connection elements (3) are disposed in a line,

2. Pane according to claim 1, wherein the angle between the solder region (10) and the crimped region (11) is from 120° to 180°, preferably from 150° to 170°.

3. Pane according to claim 1 or 2, wherein the distance between adjacent connection elements is from 5 mm to 50 mm, particularly preferably from 10 mm to 20 mm.

4. Pane according to one of claims 1 through 3, wherein the material thickness of the connection element (3) is from 0.1 mm to 2 mm, preferably from 0.2 mm to 1 mm, particularly preferably from 0.3 mm to 0.5 mm.

5. Pane according to one of claims 1 through 4, wherein the connection element (3) comprises at least 66.5 wt.-% to 89.5 wt.-% iron, 10.5 wt.-% to 20 wt.-% chromium, 0 wt.-% to 1 wt.-% carbon, 0 wt.-% to 5 wt.-% nickel, 0 wt.-% to 2 wt.-% manganese, 0 wt.-% to 2.5 wt.-% molybdenum, 0 wt.-% to 2 wt.-% niobium and 0 wt.-% to 1 wt.-% titanium.

6. Pane according to claim 5, wherein the connection element (3) comprises at least 77 wt.-% to 84 wt.-% iron, 16 wt.-% to 18.5 wt.-% chromium, 0 wt.-% to 0.1 wt.-% carbon, 0 wt.-% to 1 wt.-% manganese, 0 wt.-% to 1 wt.-% niobium, 0 wt.-% to 1.5 wt.-% molybdenum, and 0 wt.-% to 1 wt.-% titanium.

7. Pane according to one of claims 1 through 6, wherein the substrate (1) contains glass, preferably flat glass, float glass, quartz glass, borosilicate glass, and/or soda lime glass.

8. Pane according to one of claims 1 through 7, wherein the electrically conductive structure (2) contains at least silver, preferably silver particles and glass frits and has a layer thickness of 5 µm to 40 µm.

9. Pane according to one of claims 1 through 8, wherein the layer thickness of the solder material (4) is less than or equal to 6.0 x 10⁻⁴ m.

10. Pane according to one of claims 1 through 9, wherein the solder material (4) contains tin and bismuth, indium, zinc, copper, silver, or compositions thereof.

11. Pane according to claim 10, wherein the solder material (4) contains 35 wt.-% to 69 wt.-% bismuth, 30 wt.-% to 50 wt.-% tin, 1 wt.-% to 10 wt.-% silver, and 0 wt.-% to 5 wt.-% copper, or wherein the solder material (4) contains 90 wt.-% to 99.5 wt.-% tin, 0.5 wt.-% to 5 wt.-% silver, and 0 wt.-% to 5 wt.-% copper.

12. Pane according to one of claims 1 through 11, wherein the connection element (3) has at least a wetting layer (6) that contains nickel, tin, copper, and/or silver.

13. Method for production of a pane with at least one electrical connection element according to one of claims 1 through 12, wherein
a) the connection element (3) is connected to the connection cable (5) by crimping in a region (11),
b) solder material (4) is applied on the bottom of the solder region (10),
c) the connection element (3) with the solder material (4) is disposed on a region of an electrically conductive structure (2) that is applied on a region of a substrate (1), and
d) the connection element (3) is connected, with energy input, to the electrically conductive structure (2).

14. Use of a pane with at least one electrical connection element according to one of claims 1 through 12, in buildings or in means of transportation for travel on land, in the air, or on water, in particular in rail vehicles or motor vehicles, preferably as a windshield, rear window, side window, and/or glass roof, in particular as a heatable pane or as a pane with an antenna function.

## Revendications

1. Une vitre avec au moins un élément de connexion électrique (3), qui comprend au moins:
- un substrat (1), qui a un premier coefficient de dilatation thermique, où le premier coefficient de dilatation thermique est de 8 x 10⁻⁶/°C à 9 x 10⁻⁶/°C,
- sur une zone du substrat (1) une structure électriquement conductrice (2),
- sur une zone de la structure électriquement conductrice (2), au moins un élément de connexion (3), où l'élément de connexion (3) présente une zone sertie (11) autour d'un câble de raccordement (5) et une zone de soudage (10) et où la zone de soudage (10) est reliée à l'aide d'une masse de brasure sans plomb (4) avec la structure conductrice (2), où l'élément de connexion (3) contient au moins un acier contenant du chrome, dont la teneur en chrome est égale ou supérieur à 10,5% en poids, où l'élément de connexion (3) présente un deuxième coefficient de dilatation thermique, où le deuxième coefficient de dilatation thermique est compris entre 9 x 10⁻⁶/°C et 13 x 10⁻⁶/°C, et la différence entre le premier coefficient de dilatation thermique et le deuxième coefficient de dilatation thermique est inférieure à 5 x 10⁻⁶/°C, et où deux à six éléments de connexion (3) sont disposés sur une ligne.

2. Vitre selon la revendication 1, où l'angle entre la zone de soudage (10) et la zone sertie (11) se situe entre 120° et 180°, de préférence entre 150° et 170°.

3. Vitre selon la revendication 1 ou 2, où la distance entre les éléments de connexion adjacents se situe entre 5 mm et 50 mm, de manière particulièrement préférée entre 10 mm et 20 mm.

4. Vitre selon la revendication 1 ou 3, où l'épaisseur de matériau de l'élément de connexion (3) se situe entre 0,1 mm et 2 mm, de préférence entre 0,2 mm et 1 mm, de manière particulièrement préférée entre 0,3 mm et 0,5 mm.

5. Vitre selon l'une des revendications 1 à 4, où l'élément de connexion (3) contient au moins 66,5% à 89,5% en poids de fer, 10,5% à 20% en poids de chrome, 0% à 1% en poids de carbone, 0% à 5% en poids de nickel, 0% à 2% en poids de manganèse, 0% à 2,5% en poids de molybdène, 0% à 2% en poids de niobium et 0% à 1% en poids de titane..

6. Vitre selon la revendication 5, où l'élément de connexion (3) contient au moins 77% à 84% en poids de fer, 16% à 18,5% en poids de chrome, 0% à 0,1% en poids de carbone, 0% à 1% en poids de manganèse, 0% à 1% en poids de niobium, 0 % à 1,5% en poids de molybdène et 0% à 1% en poids de titane.

7. Vitre selon l'une des revendications 1 à 6, où le substrat (1) contient du verre, de préférence du verre plat, du verre flotté, du verre de quartz, du verre borosilicaté et/ou du verre sodocalcique.

8. Vitre selon l'une des revendications 1 à 7, où la structure électriquement conductrice (2) contient au moins de l'argent, de préférence des particules d'argent et des frittes de verre et présente une épaisseur de couche de 5 µm à 40 µm.

9. Vitre selon l'une des revendications 1 à 8, où l'épaisseur de la masse de brasure (4) est inférieure ou égal à 6,0 x 10⁻⁴ m.

10. Vitre selon l'une des revendications 1 à 9, où la masse de brasure (4) contient de l'étain et bismuth, de l'indium, du zinc, du cuivre, de l'argent ou des mélanges de ceux-ci.

11. Vitre selon la revendication 10, où la masse de brasure (4) contient de 35% à 69% en poids de bismuth, de 30% à 50% en poids d'étain, de 1% à 10% en poids d'argent et 0 % à 5% en poids de cuivre ou où la masse de brasure (4) contient de 90% à 99,5% en poids d'étain, de 0,5% à 5% en poids d'argent et de 0% à 5% en poids de cuivre.

12. Vitre selon l'une des revendications 1 à 11, où le l'élément de connexion (3) présente au moins une couche de mouillage (6) qui contient du nickel, de l'étain, du cuivre et / ou de l'argent.

13. Procédé de fabrication d'une vitre avec au moins un élément de connexion électrique selon l'une des revendications 1 à 12, où
a) l'élément de connexion (3) par sertissage est relié avec un câble de raccordement (5) par sertissage dans une zone (11),
b) la masse de brasure (4) est appliquée sur la face inférieure de la zone de soudage (10),
c) l'élément de connexion (3) est disposé par la masse de soudure (4) sur une zone d'une structure électriquement conductrice (2), qui est déposée sur une zone d'un substrat (1) et
d) l'élément de connexion (3) est relié moyennant un apport d'énergie à la structure électriquement conductrice (2).

14. Utilisation d'une vitre avec au moins un élément de connexion électrique selon l'une des revendications 1 à 12, dans les bâtiments ou dans les moyens de locomotion pour le transport sur la terre, dans l'air ou dans l'eau, en particulier dans des véhicules ferroviaires ou des véhicules à moteur, de préférence comme pare-brise, lunette arrière, vitre latérale et/ou vitre de toit, en particulier comme vitre chauffante ou vitre avec fonction d'antenne.
